# EUROPEAN PATENT APPLICATION

(11) **EP 4 811 938 A1**
(43) Date of publication of application: **23.09.2026**
(21) Application number: 26165614.4
(22) Date of filing: 17.03.2026
(51) Int. Cl.: H05K 1/184, H05K 3/46

(54) **PRINTED CIRCUIT BOARD WITH EMBEDDED SMD DEVICE**

(30) Priority: 18.03.2025 CN 202510320101
(71) Applicant: Littelfuse Semiconductor (Wuxi) Co., Ltd., Wuxi, Jiangsu 214142 (CN)
(72) Inventor: Chin, Fang Chuan, Wuxi, 214142 (CN); Hsieh, Jordan, Wuxi, 214142 (CN)
(74) Representative: Arnold & Siedsma

(57) **Abstract**

A printed circuit board (PCB) assembly is disclosed. The printed circuit board assembly may include a PCB body, as well as a set of vias, disposed within the PCB body. The printed circuit board assembly may further include a set of devices, disposed within the set of vias, respectively.

## Description

### Background

### Field

The disclosure relates to the field of surface mount device technology, and in particular, printed circuit boards having surface mount devices.

### Discussion of Related Art

Printed circuit boards (PCBs) are commonly arranged with electrical components that may be mounted to the printed circuit board. A common arrangement is referred to as surface mount technology (SMT) where the electrical components are placed directly on the surface of the printed circuit board. Such devices are generally referred to as a surface mounted device (SMD), and may include capacitors, resistors, inductors, diodes, electrostatic discharge protection devices, semiconductors, or other components. The advantages of SMT include smaller components and higher component density as compared to older through hole technology.

PCBs may be found in many electronic or electrical devices, including portable electronic devices where space considerations dictate the efficient design of PCBs.

### Brief Summary

A printed circuit board (PCB) assembly is provided. The printed circuit board assembly may include a PCB body, as well as a set of vias, disposed within the PCB body, and a set of devices, disposed within the set of vias, respectively.

The PCB body may include a plurality of substrate layers, formed of an insulating material. The PCB assembly may further include a plurality of embedded conductive layers arranged in an alternating fashion between with the plurality of substrate layers; and a plurality of device vias, disposed within the PCB body, wherein each device via includes a device, disposed therein.

### Brief Description of the Drawings

**FIG. 1A** depicts a side cross-sectional view of a PCB assembly, according to the disclosure;
**FIG. 1B** depicts a top plan view of the PCB assembly of FIG. 1A;
**FIG. 1C** depicts a side cross-sectional view of a reference PCB assembly;
**FIG. 1D** depicts a top plan view of the reference PCB assembly of FIG.1C;
**FIG. 2A** depicts a side cross-sectional view of a PCB assembly, according to the disclosure; and
**FIG. 2B** depicts a top plan view of the PCB assembly of FIG. 2A.

### Description of Embodiments

The disclosure will now be described more fully hereinafter with reference to the accompanying drawings, in which examples are shown. In the drawings, like numbers refer to like elements throughout.

In the following description and/or claims, the terms "on," "overlying," "disposed on" and "over" may be used in the following description and claims. "On," "overlying," "disposed on" and "over" may be used to indicate that two or more elements are in direct physical contact with one another. Also, the term "on,", "overlying," "disposed on," and "over", may mean that two or more elements are not in direct contact with one another. For example, "over" may mean that one element is above another element while not contacting one another and may have another element or elements in between the two elements. Furthermore, the term "and/or" may mean "and", it may mean "or", it may mean "exclusive-or", it may mean "one", it may mean "some, but not all", it may mean "neither", and/or it may mean "both", although the scope of claimed subject matter is not limited in this respect.

The disclosure provides a novel arrangement of PCBs, where devices, such as traditional surface mount device (SMDs) are incorporated within a PCB. By incorporating the SMDs within a PCB, the overall height of a PCB assembly, including SMDs is reduced in comparison to known PCB arrangements.

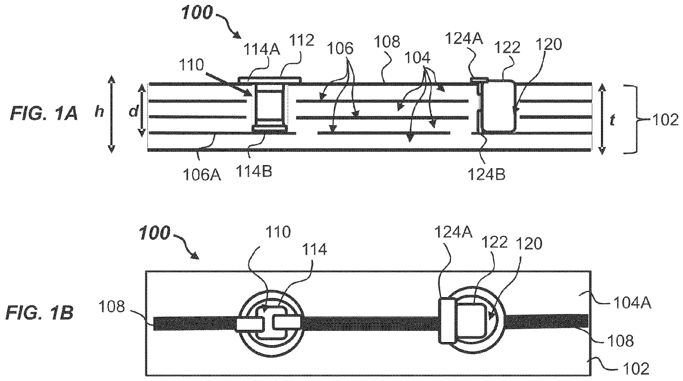

**FIG. 1A** depicts a side cross-sectional view of a PCB assembly 100, according to the disclosure. **FIG. 1B** depicts a top plan view of the PCB assembly 100 of FIG. 1A.

The PCB assembly 100 includes PCB body 102. The PCB body 102 may include at least one substrate layer, shown as substrate layers 104, generally formed of a known electrical insulator material, such as a mixture of polymer resin and glass, ceramic material, and so forth.

With a plurality of substrate layers 104, the different ones of the substrate layers 104 may be formed of the same insulator material, or the composition and/or materials of the different ones of substrate layers 104 may differ between the different ones of substrate layers 104. In one non-limiting example, the PCB body 102 may include four substrate layers 104, as depicted in FIG. 1A.

The PCB body 102 may further include one or more embedded conductor layers, shown as embedded layers 106, arranged in planar fashion between adjacent ones of the substrate layers 104. The embedded layers 106 may be patterned. For example, the embedded layers 106 may be formed of a copper foil that may be unpatterned.

In one example, the PCB body 102 may be formed by forming multiple layers (corresponding to substrate layers 104) of epoxy-infused fiberglass sheet (which may be known as prepreg) and placing conductive material, such as metal sheets, corresponding to embedded layers 106 in alternating fashion between adjacent prepreg layers. This multilayer stack of alternating layers of substrate layers 104 and embedded layers 106 may next be subjected to high temperature and pressure to form the PCB body 102 in a cured state. Such fabrication process is well known in the art, and will not be detailed further herein.

In one non-limiting example where the PCB body includes four of the substrate layers 104, the total thickness of the PCB body 102 may be 1 mm. In the present embodiment, the PCB assembly 100 may include any suitable number of devices that will be referred to collectively herein as SMDs.

FIG. 1A and FIG. 1B illustrates a configuration where the PCB body 102 includes multiple recesses or holes, which will be referred to as vias. These vias act as device vias, meaning that the vias are used to accommodate a device within a given via. For simplicity, just a via 110 and a via 120 are shown. However, it may be understood that the PCB body 102 may include several or many vias. Note that the vias, such as via 110 and via 120 may be formed to a certain depth within the PCB body 102, and may not necessarily be through holes.

In FIG. 1A, for simplicity of illustration, the via 110 and via 120 are formed to a via depth *d* from the top surface of the PCB body 102, where the via depth is approximately equivalent to the thickness of three of the substrate layers 104 (and including the thickness of three of the embedded layers 106).

As shown in FIG. 1A, a first SMD, referred to as device 112, is disposed within a first via, meaning the via 110, while a second device, shown as device 122, is disposed within a second via, meaning the via 120. The device 112 may represent a capacitor for instance. In the arrangement of FIG. 1A, the device 112 may have electrodes that are arranged in a planar configuration, extending parallel to the plane of substrate layers 104. In this configuration, a top electrode 114A is arranged to electrically connect to a surface trace 108, while a bottom electrode 114B may connect to an embedded layer 106A, such as a copper sheet.

The device 114 may represent any other suitable device, including a bare semiconductor die, or a molded device, for example. For simplicity of illustration, In this configuration, a top electrode 124A is arranged on one side of the device 122, and is arranged to electrically connect to a surface trace 108, while a bottom electrode 124B, arranged on the same side of device 122, may connect to the embedded layer 106A.

In FIG. 1B, the via 110 and via 120 may have a circular cross-section in the top plan view. The vias may have a different shape in plan view. The circular shape for via 110 and via 120 may be imparted using a known drilling process, for example.

Note that in the configuration of FIG. 1A, the device 112 and device 122 are embedded within the PCB body 102, meaning that at least a majority of the device 112 and device 122 does not extend above the top surface of the PCB body 102. As a result, one hallmark of the PCB assembly 100 is that the overall height of the PCB is relatively smaller than in known PCB configurations. This overall height is shown as height h, which includes the distance from the lower surface of the PCB body 102 to the highest point of a device incorporated in the PCB assembly 100. In one non-limiting example, the height h may be equivalent to the thickness t of the PCB body 102, meaning that no device extends above the upper surface of the PCB body 102. Thus, where *t =* 1 mm, *h* will also equal to 1 mm. In the illustration of FIG. 1A the top electrode 114A and/or the bottom electrode 114B may extend very slightly above the top surface of PCB body 102, such as up to a few tens of micrometers. Thus, in one non-limiting example, merely for the purposes of illustration, the thickness t may equal 1.00 mm, while the height h is equal to 1.04 mm.

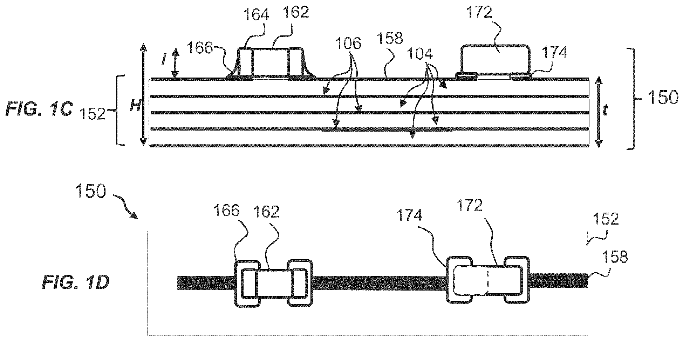

One advantage of the example of FIG. 1A is that a PCB assembly 100 can be arranged with multiple SMD devices while maintaining a relatively lower overall thickness to the assembly is maintained. To explain this advantage a reference PCB assembly is shown in FIG. 1C and FIG. 1D. **FIG. 1C** depicts a side cross-sectional view of a reference PCB assembly 150, while **FIG. 1D** depicts a top plan view of the reference PCB assembly 150 of FIG. 1C. Note that the reference PCB assembly 150 is depicted for clarity of illustration and may not represent any known PCB assembly.

In the example of FIG. 1C, the layer structure of the PCB body 152 may be generally formed as described above with respect to PCB body 102, with like elements labeled the same. However, in this example, the PCB body 152 does not include any device vias, as in FIG. 1A and FIG. 1B. Rather, a device 162 and a device 172 are provided on the top surface of PCB body 152. The device 162 may be a capacitor or resistor, for example. The device 162 may be electrically connected to the top trace 158, such as through electrodes 164 and solder 166, as shown. Likewise, the device 172 may be a bare semiconductor die or a molded device, similar to device 122. The device 172 may also be electrically connected to the top trace 158 using connections 174, such as solder.

For purposes of comparison it may be assumed that the device 162 and device 172 collectively perform the same functions as device 112 and device 122. Thus, in operation, reference PCB assembly 150 may perform similarly (not necessarily the same as) to PCB assembly 100. However, in one example, the device 162 and/or the device 172, being disposed on the top surface of the PCB body 152, may extend a distance *l* above the top surface of the PCB body 152. As a result, the total height of the reference PCB assembly 150, shown as H. In some realistic examples, the distance *l* representing the height of the device 162 or device 172, may be approximately 0. 3mm. Thus, in the example where the thickness *t* is 1 mm for PCB body 152, the height of the reference PCB assembly 150 *H* may be 1.3 mm. In comparison, the height of the PCB assembly 100, providing the same functionality as reference PCB assembly 150, may be just 1.0 mm. Said differently, the height of the reference PCB assembly 150 is this example is 30% greater than the height of the PCB assembly 100.

Another advantage of the configuration of FIG. 1A and FIG. 1B is that layout area on the surface of the PCB body may be reduced compared to the configuration of FIG. 1C. For example, assuming the device 122 and device 172 are the same device having dimensions of 0.6 mm x 0. 3mm along two different directions, the vertical arrangement of the device 122 is FIG. 1A presents a planar layout area (shown in FIG. 1B) of just 0.3 mm x 0.3 mm. On the other hand, the horizontal arrangement of the device 172 in FIG. 1C presents a planar layout area, FIG. 1D of 0.3 mm x 0.6 mm, or twice that area of the embodiment of FIG. 1A (see dashed line in FIG. 1D for comparison).

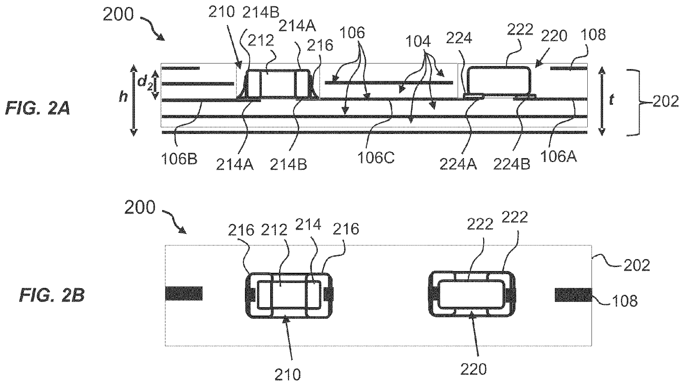

**FIG. 2A** depicts a side cross-sectional view of a PCB assembly 200, according to embodiments of the disclosure. **FIG. 2B** depicts a top plan view of the PCB assembly 200 of FIG. 2A.

The PCB assembly 200 includes PCB body 202. Like PCB body 102, the PCB body 202 may include at least one substrate layer, shown as substrate layers 104, discussed above. The PCB body 202 may further include one or more embedded conductor layers, shown as embedded layers 106, as discussed above.

In one non-limiting example where the PCB body 202 includes four of the substrate layers 104, the total thickness of the PCB body 202 may also be 1 mm. In the present embodiment, the PCB assembly 200 may include any suitable number of devices that will be referred to collectively herein as SMDs.

FIG. 2A and FIG. 2B illustrate a configuration where the PCB body 202 includes multiple recesses or holes, which will be referred to as vias. These vias act as device vias, as described above. For simplicity, just a via 210 and a via 220 are shown. However, it may be understood that the PCB body 202 may include several or many vias. Note that the vias, such as via 210 and via 220 may be formed to a certain depth within the PCB body 202, and may not necessarily be through holes.

In FIG. 2A, for simplicity of illustration, the via 210 and via 220 are formed to a via depth *d₂* from the top surface of the PCB body 202, where the via depth is approximately equivalent to the thickness of two of the substrate layers 104 (and including the thickness of two of the embedded layers 106).

As shown in FIG. 2A, a first SMD, referred to as device 212, is disposed within a first via, meaning via 210, while a second device, shown as device 222, is disposed within a second via, meaning the via 220. The device 212 may represent a capacitor for instance. In the arrangement of FIG. 1A, the device 212 may have electrodes that are arranged in a vertical configuration, extending perpendicular to the plane of substrate layers 104. In this configuration, a first electrode 214A and a second electrode 214B are arranged to electrically connect (for example, with aid of solder 216) to an embedded layer 106B, and embedded layer 106C, respectively, such as a copper sheet.

The device 222 may represent any other suitable device, including a bare semiconductor die, or a molded device, for example. For simplicity of illustration, in this configuration, a first lower electrode 224A and a second lower electrode 224B (collectively electrodes 224) are arranged to also connect to embedded layer 106C and embedded layer 106A, respectively.

In FIG. 2B, the via 210 and via 220 may have a rectangular cross-section in the top plan view. The vias may have a different shape in plan view..

As with the configuration of FIG. 1A, the device 212 and device 222 are embedded within the PCB body 152, meaning that at least a majority of the device 212 and device 222 does not extend above the top surface of the PCB body 152. This overall height is also shown as height *h*, which includes the distance from the lower surface of the PCB body 152 to the highest point of a device incorporated in the PCB assembly 150 or a top surface of the PCB body 102. In one non-limiting example, the height *h* may be equivalent to the thickness *t* of the PCB body 152, meaning that no device extends above the upper surface of the PCB body 152. Thus, in an embodiment where *t =* 1 mm, *h* will also equal to 1 mm. In the illustration of FIG. 2A the device 212 and device 222 may be arranged in the via 210 and the via 220 such that these devices do not extend above the upper surface of PCB body 152. Thus, in one non-limiting example, merely for the purposes of illustration, where the thickness *t* may equal 1.00 mm, the height *h* may also equal to 1.00 mm.

An advantage of the configuration of FIG. 2A and FIG. 2B is that the respective vias, via 210 and via 220 may be arranged with a large enough area in top plan view so as to accommodate the device 212 and device 222, respectively, as shown. In particular, the longer dimension of device 212, extending between first electrode 214A and second electrode 214B, lies parallel to the plane of the substrate layers 104, while the shorter dimension of device 212 extends perpendicularly to the plane of the substrate layers 104. Moreover, the longer dimension of device 222 lies parallel to the plane of the substrate layers 104, while the shorter dimension of device 222 extends perpendicularly to the plane of the substrate layers 104. This geometry means that the via 210 and via 220 may be removed to a shallower depth as compared to the depth of via 110 or via 120. A drawback is that the via 210 and via 220 may have a larger cross-sectional area and may need to be fabricated in a rectangular shape in top plan view, to accommodate the device 212 and device 222, respectively.

In the disclosure a PCB assembly may be arranged with a plurality of vias, where the depth of vias may differ from one another. Thus, a first via may extend through three layers of a PCB body, while a second via extends through just two layers of a PCB body. Moreover, the shape of the vias within a PCB body may differ among different vias, where a first via presents a rectangular shape in top plan view, while a second via presents a circular shape.

## Claims

1. A printed circuit board (PCB) assembly, comprising:
a PCB body;
a set of vias, disposed within the PCB body; and
a set of devices, disposed within the set of vias, respectively.

2. The PCB assembly of claim 1, wherein the PCB body comprises:
a plurality of substrate layers, formed of an insulating material; and
a plurality of embedded layers, formed of a conductive material, and disposed in an alternating fashion between adjacent ones of the plurality of substrate layers.

3. The PCB assembly of claim 1 or 2, wherein the set of devices comprises a set of surface mounted devices.

4. The PCB assembly of any of the claims 1-3, wherein the set of devices do not extend above a top surface of the PCB body.

5. The PCB assembly of any of the preceding claims, wherein the set of vias have a circular shape in top plan view.

6. The PCB assembly of any of the preceding claims 1-4, wherein the set of vias have a rectangular shape in top plan view.

7. The PCB assembly of any of the preceding claims wherein the PCB body comprises:
a plurality of substrate layers, formed of an insulating material.

8. The PCB assembly of claim 7, further comprising a plurality of embedded layers, formed of a conductive material, and disposed in an alternating fashion between adjacent ones of the plurality of substrate layers.

9. The PCB assembly of claim 8, wherein at least one electrode of at least one device of at least one via of the set of vias is electrically connected to an embedded layer of the plurality of embedded layers.

10. The PCB assembly of any of the preceding claims, wherein the set of vias do not extend through an entirety of a thickness of the PCB body.

11. The PCB assembly of any of the preceding claims, wherein a height of the PCB assembly is equivalent to a thickness of the PCB body.

12. The PCB assembly of any of the preceding claims 8-11, wherein the embedded layers are formed of a copper foil.

13. The PCB assembly of claim 12, wherein the copper foil is unpatterned.

14. Use of a PCB assembly according to any of the preceding claims in an may be found in electronic or electrical devices.

15. Use according to claim 14 in a portable electronic or electrical device.
